# DEMANDE DE BREVET EUROPEEN

(11) **EP 4 757 511 A1**
(43) Date de publication de la demande: **10.06.2026**
(21) Numéro de dépôt: 24307048.9
(22) Date de dépôt: 06.12.2024
(51) Int. Cl.: H05K 7/14

(54) **SUPPORT DE FIXATION POUR UNE ARMOIRE DE SUPERCALCULATEUR**

(71) Demandeur: BULL SAS, 78340 Les Clayes-Sous-Bois (FR)
(72) Inventeur: MARGARIAN, Levon, 49000 ANGERS (FR); ROCHEREAU, Antoine, 49100 ANGERS (FR)
(74) Mandataire: Argyma

(57) **Abrégé**

L'invention concerne un support de fixation (30) pour une armoire (1) de supercalculateur, comprenant une armature extérieure (10), une armature de support (20), des lames de calcul (22) et une unité d'alimentation électrique (40) fixée sur ledit support de fixation (30), ledit support de fixation (30) comporte une pièce fixe (31) et une pièce de déport (32), ladite pièce fixe (31) étant configurée pour être montée sur l'armature extérieure (10) de l'armoire (1) et pour recevoir ladite pièce de déport (32), la pièce de déport (32) comprenant une portion principale (321) configurée pour être montée de manière réglable sur la pièce fixe (31) et une portion secondaire (322) reliée perpendiculairement à la portion principale (321) et configurée pour être fixée sur ladite armature de support (10) et pour recevoir l'unité d'alimentation électrique (40).

## Description

### [Domaine technique]

La présente invention se rapporte au domaine des armoires de supercalculateurs et concerne plus particulièrement un système de fixation pour armoire de supercalculateur.

### [Etat de la technique antérieure]

Avec l'augmentation des besoins informatiques, les centres de calculs (aussi appelées « datacenters » en anglais) se multiplient et cherchent à augmenter les performances de leur matériel informatique.

Malgré les progrès de la miniaturisation, l'augmentation de la demande entraîne une augmentation du nombre de composants présents dans les armoires, ce qui entraîne un encombrement de plus en plus important des armoires de supercalculateurs. Cet encombrement rend difficile les opérations de maintenance.

De même, l'augmentation du nombre de composants ainsi que de leurs besoins en puissance électrique entraîne une demande accrue d'alimentation électrique, qui entraîne donc la nécessité de multiplier les unités d'alimentation électrique dans ces armoires de supercalculateur. Ces composants devant être refroidis, les circuits de refroidissement prennent également plus de place.

Une solution évidente est d'augmenter la taille des armoires de supercalculateurs afin de s'adapter à l'augmentation des composants et des besoins en alimentation, ou d'augmenter le nombre d'armoires de supercalculateurs. Cependant, cette augmentation provoque une empreinte environnementale démultipliée des centres de calculs, du fait de leur taille et de leur consommation électrique, qui serait désavantageuse vis-à-vis des enjeux climatiques et environnementaux actuels.

Une autre solution est de proposer des formes d'armoires spécifiques qui sont déjà optimisées pour leur usage prédéterminé. Cependant, ces armoires sont optimisées pour un certain type d'équipements et pour un aménagement interne spécifique. Dès que les armoires doivent recevoir des composants sortant de cette prévision, l'agencement optimal n'est plus atteignable. Ce type de dispositif ne résout donc pas les problèmes en dehors de ces cas spécifiques.

Il existe donc un besoin d'une solution simple et efficace permettant de remédier au moins en partie à ces inconvénients.

### [Exposé de l'invention]

Dans ce but, l'invention a tout d'abord pour un objet un support de fixation pour une armoire de supercalculateur, ladite armoire présentant une forme parallélépipédique comportant une face avant, une face arrière, deux faces latérales, une armature extérieure, une armature de support configurée pour recevoir une pluralité de lames de calcul superposées verticalement et configurées pour être insérées et retirées de ladite armoire par coulissement à travers la face arrière de l'armoire, et au moins une unité d'alimentation électrique configurée pour alimenter électriquement les composants des lames de calcul et pour être fixée sur ledit support de fixation, ledit support de fixation étant remarquable en ce qu'il comporte une pièce fixe et une pièce de déport, ladite pièce fixe étant configurée pour être montée sur l'armature extérieure de l'armoire en s'étendant dans un plan parallèle au plan de la face latérale et pour recevoir ladite pièce de déport, la pièce de déport comprenant une portion principale configurée pour être montée de manière réglable sur la pièce fixe en s'étendant dans un plan parallèle au plan de ladite pièce fixe et une portion secondaire reliée à la portion principale en s'étendant perpendiculairement au plan de ladite portion principale, ladite portion secondaire étant configurée pour être fixée sur ladite armature de support et pour recevoir l'au moins une unité d'alimentation électrique.

Le support de fixation selon l'invention permet de fixer la ou les unités d'alimentation électrique nécessaires au fonctionnement de l'armoire de supercalculateur entre l'armature externe et l'armature de support en les enfonçant plus en profondeur, ce qui permet d'utiliser un espace qui est inoccupé dans les armoires standards de l'état de la technique. Le support de fixation permet de plus de positionner les connecteurs de l'unité d'alimentation électrique face à la face arrière de l'armoire et non plus vers l'intérieur, limitant ainsi les risques d'abîmer le matériel lors de l'insertion ou de retrait des lames de calcul. Enfin, le caractère modulaire du support de fixation assuré par la fixation réglable de la pièce de déport sur la pièce fixe permet d'adapter l'utilisation du support de fixation à différents types d'armoires en fonction des besoins informatiques des utilisateurs.

Dans une forme de réalisation préférentielle, la portion secondaire de la pièce de déport est issue de même matière que la portion principale. Cette configuration permet une fabrication plus simple et efficace de la pièce de déport.

Avantageusement, la portion principale de la pièce de déport est configurée pour être fixée à la pièce fixe via un système vis-écrou. Ce système est simple et pratique à mettre en oeuvre lors du montage de l'armoire.

De préférence dans cette forme de réalisation, la pièce fixe comprend au moins une rainure de fixation à travers laquelle l'ensemble vis-écrou est fixé. Ainsi la fixation de la pièce de déport sur la pièce fixe peut se faire en deux temps : d'abord l'opérateur place la vis dans la rainure de fixation et l'orifice de fixation et règle la position, ce qui permet le maintien de la pièce de déport pendant le réglage, et une fois que le bon positionnement est trouvé, l'écrou est serré pour fixer et bloquer la pièce de déport. Cela permet un réglage précis et aisé à mettre en oeuvre.

Dans une forme de réalisation alternative, la portion principale de la pièce de déport est configurée pour être fixée à la pièce fixe via un autre système de fixation, comme un rail de fixation, par clipsage, etc.

Avantageusement, la pièce fixe et la portion principale de la pièce de déport comprennent un ensemble de perforations de fixation de câble. Ces perforations de fixation de câble permettent de ranger de manière efficace les nombreux câbles qui relient les lames de calcul entre elles et à des éléments extérieurs.

Préférentiellement, la pièce fixe comprend une portion de renfort, qui permet d'augmenter la rigidité de la pièce fixe afin notamment d'éviter des déformations sous le poids de l'unité d'alimentation électrique.

Préférentiellement encore, la portion de renfort est obtenue par pliure et prend la forme d'une pliure s'étendant en tout ou partie sur la longueur du bord longitudinal de la pièce fixe. Cette pliure longitudinale est simple à mettre en oeuvre et peut servir comme élément de fixation à insérer dans une rainure correspondante d'un des montants arrière de l'armature externe pour renforcer d'autant plus la rigidité du support de fixation.

En variante, la portion de renfort pourrait être un organe rapporté sur la pièce fixe, notamment pour permettre la fixation de la pièce fixe sur l'armature externe de l'armoire tout en conférant une rigidité supplémentaire à la pièce.

Avantageusement, la pièce de déport comprend au moins une ouverture traversante. Cette ouverture permet de réduire le poids de l'élément de support tout en permettant de réaliser des pièces de déport avec une extension plus importante pour s'adapter à des agencements spécifiques de l'armoire.

Dans une forme de réalisation préférentielle, la pièce fixe et la pièce de déport sont réalisées en un matériau métallique, en aluminium par exemple.

Dans une forme de réalisation de la portion principale, celle-ci comprend une première plaque et une seconde plaque, lesdites première plaque et seconde plaque s'étendant dans deux plans parallèles en étant fixées entre elles, par exemple par soudage, ou bien en étant issues de même matière, par pliage ou moulage par exemple.

Selon un autre aspect, l'invention concerne également une armoire de supercalculateur présentant une forme parallélépipédique comportant une face avant, une face arrière, deux faces latérales, une armature extérieure, une armature de support configurée pour recevoir une pluralité de lames de calcul superposées verticalement et configurées pour être insérées et retirées de ladite armoire par coulissement à travers la face arrière de l'armoire, au moins une unité d'alimentation électrique configurée pour alimenter électriquement les composants des lames de calcul et au moins un support de fixation tel que présenté fixé à l'armature extérieure de l'armoire. Cette armoire présente un aménagement intérieur optimisé grâce au support de fixation utilisé et présente moins de risques d'abîmer les unités d'alimentation électrique lors de l'insertion et du retrait des lames de calcul.

Selon encore un autre aspect, l'invention concerne également un procédé de montage d'une armoire de supercalculateur telle que présentée, mis en oeuvre par un opérateur et comprenant les étapes de :
- montage de l'armature externe de l'armoire de supercalculateur,
- montage l'armature de support, fixée à l'armature externe,
- fixation de la pièce fixe du support de fixation à l'armature externe,
- positionnement de la pièce de déport du support de fixation par rapport à la pièce fixe,
- fixation de la pièce de déport à la pièce fixe et à l'armature de support,
- fixation de l'unité d'alimentation électrique sur la pièce de déport ainsi fixée,
- insertion de la pluralité de lames de calcul superposées verticalement dans l'armature de support,
- raccordement des lames de calcul insérées à l'unité d'alimentation électrique fixée afin d'alimenter électriquement les lames de calcul.

Ce procédé permet de monter de façon simple, rapide et efficace l'armoire avec au moins un support de fixation selon l'invention.

### [Description des dessins]

D'autres caractéristiques et avantages de l'invention apparaîtront encore à la lecture de la description qui va suivre. Celle-ci est purement illustrative et doit être lue en regard des dessins annexés sur lesquels :
[Fig 1] La figure 1 illustre schématiquement une vue en perspective d'une armoire de supercalculateur comprenant un support de fixation selon l'invention.
[Fig 2] La figure 2 illustre schématiquement une vue de la pièce fixe du support de fixation selon l'invention.
[Fig 3] La figure 3 illustre schématiquement une vue d'une première forme de réalisation de la pièce de déport du support de fixation selon l'invention.
[Fig 4] La figure 4 illustre schématiquement une vue d'une deuxième forme de réalisation de la pièce de déport du support de fixation selon l'invention.
[Fig 5] La figure 5 illustre schématiquement une vue du support de fixation avec la pièce de déport fixée à la pièce fixe ainsi qu'une unité d'alimentation électrique fixée à la pièce de déport.
[Fig 6] La figure 6 illustre schématiquement le procédé de montage d'une armoire de supercalculateur selon l'invention.

### [Description des modes de réalisation]

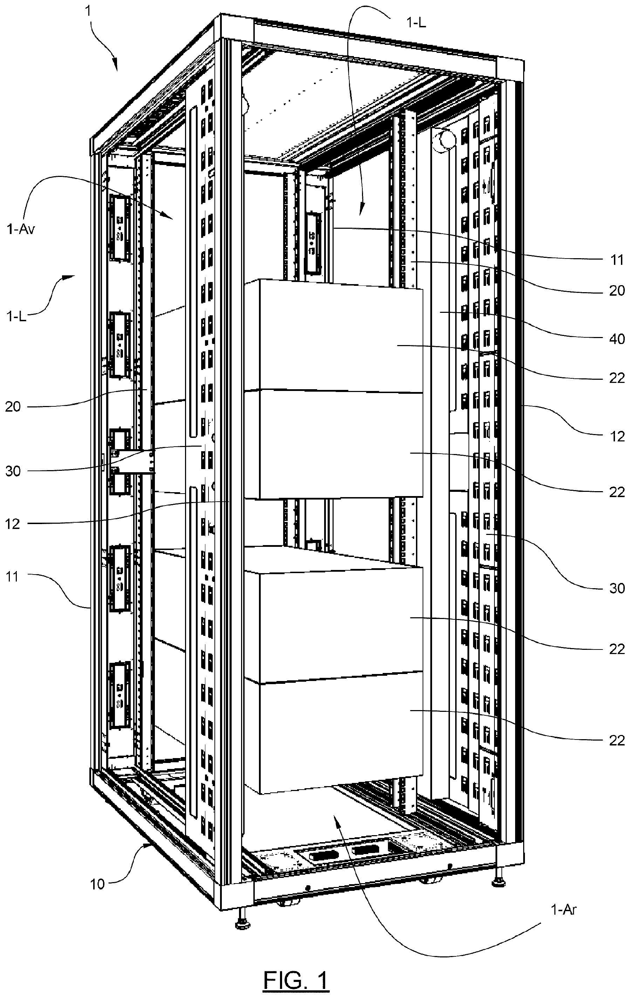

La figure 1 illustre schématiquement un exemple d'armoire 1 de supercalculateur comprenant un support de fixation 30 selon l'invention.

### Armoire 1

Comme représenté sur la figure 1, l'armoire 1 est de forme parallélépipédique et comprend une armature externe 10, une armature de support 20, deux supports de fixation 30 et une unité d'alimentation électrique 40.

L'armature externe 10 de l'armoire 1 comprend des montants verticaux et horizontaux formant les arrêtes extérieures de l'armoire 1. Ces montants définissent une face avant 1-Av, une face arrière 1-Ar et deux faces latérales 1-L.

En particulier, l'armature externe 10 comprend deux montants avant 11 qui s'étendent verticalement de part et d'autre de la face avant 1-Av, et deux montants arrière 12 qui s'étendent verticalement de part et d'autre de la face arrière 1-Ar.

L'armature de support 20 comprend une pluralité de lames de calcul 22 qui sont superposées les unes aux autres. Les lames de calcul 22 peuvent être insérées et retirées de l'armoire 1 par coulissement à travers la face arrière 1-Ar.

Les lames de calculs 22 contiennent les composants informatiques permettant de traiter un grand nombre de données informatiques.

Chaque support de fixation 30 comporte une pièce fixe 31 et une pièce de déport 32. Dans une forme de réalisation préférentielle, la pièce fixe 31 et la pièce de déport 32 sont des pièces métalliques d'un seul tenant, réalisées en aluminium par exemple.

La pièce fixe 31 est fixée à l'armature externe 10 de l'armoire 1 en s'étendant dans un plan parallèle au plan d'une des faces latérales 1-L.

Avantageusement, l'armoire 1 comprend deux supports de fixation 30, situés de part et d'autre de l'armature de support 20 parallèlement aux deux faces latérales 1-L.

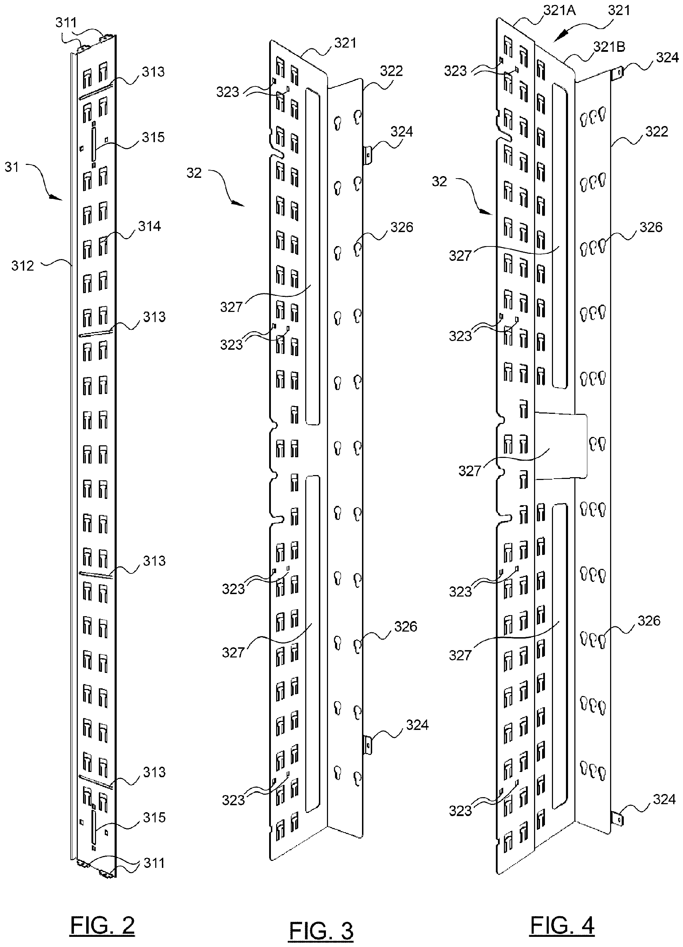

La pièce fixe 31 comprend un ensemble d'organes de fixation 311 qui permettent le montage du support de fixation 30 à l'armature externe 10. Dans la forme de réalisation représentée sur la figure 2, ces organes de fixation 311 sont des portions métalliques pliées perpendiculairement au plan dans lequel s'étend la pièce fixe 31 et comprenant des orifices qui permettent de visser le haut et le bas de la pièce fixe 31 à l'armature externe 10.

Dans la forme de réalisation représentée sur la figure 1, la pièce fixe 31 est fixée en haut et en bas à l'armature externe 10.

Comme représenté sur la figure 2, la pièce fixe 31 comprend une pliure longitudinale 312 qui assure la rigidité de la pièce fixe 31. La pliure longitudinale 312 est également insérée dans le rail du montant arrière 12 pour assurer le maintien du support de fixation 30.

La pièce fixe 31 comprend une pluralité de rainures de fixation 313. Ces rainures de fixation 313 s'étendent perpendiculairement à la direction longitudinale de la pièce fixe 31 et sont destinées à recevoir un ensemble vis-écrou pour la fixation de la pièce de déport 32.

De préférence, la pièce fixe 31 comprend un ensemble de perforations de fixation de câble 314 et un ensemble de perforations de fixations de circuits liquides 315.

Les perforations de fixation de câble 314 permettent de guider er maintenir les câbles reliant les lames de calcul 22 à d'autres armoires 1 ou bien à des ordinateurs, au réseau internet, etc.

Comme représenté sur la figure 2, ces perforations de fixation de câble 314 consistent en des ouvertures rectangulaires dans la pièce fixe 31 dans laquelle s'étend une languette issue de même matière se terminant par une portion évasée. La languette est déportée par rapport au plan de la pièce fixe 31.

Les perforations de fixations de circuits liquides 315 permettent de fixer les conduites pour le système de refroidissement des lames de calcul 22.

Comme représenté sur les figures 3 et 4, la pièce de déport 32 comprend une portion principale 321 et une portion secondaire 322.

La portion principale 321 est montée de manière réglable sur la pièce fixe 31 en s'étendant dans un plan parallèle au plan de ladite pièce fixe 31, et comprend un ensemble d'orifices de fixations 323 qui permettent de fixer la pièce de déport 32 à la pièce fixe 31 en enfilant un ensemble vis-écrou à travers lesdits orifices de fixation 323 et les rainures de fixation 313.

Comme la pièce fixe 31, la portion principale 321 comprend un ensemble de perforations de fixation de câble 325. Comme représenté sur les figures 3 et 4, les perforations de fixation de câble 325 sont réparties en une grille comprenant une pluralité de lignes et de colonnes.

Sur la forme de réalisation représentée sur la figure 3, la portion principale 321 comprend deux colonnes de perforations de fixation de câble 325.

Sur la forme de réalisation représentée sur la figure 4, la portion principale 321 est plus large et comprend une première plaque 321A et une seconde plaque 321B, lesdites première plaque 321A et seconde plaque 321B s'étendant dans deux plans parallèles en étant fixées entre elles, par exemple par soudage. Deux colonnes de perforations de fixation de câble 325 sont formées dans la première plaque 321A et une est formée dans la seconde plaque 321B.

Comme représenté sur les figures 3 et 4, la portion principale 321 comprend une ou plusieurs ouvertures traversantes 327, qui permet d'alléger le support de fixation 30 tout en ayant une extension importante.

Dans la forme de réalisation de la pièce de déport 32 représentée sur la figure 4, les ouvertures traversantes 327 sont situées sur la second plaque 321B.

Sur la forme de réalisation représentée sur les figures 3 et 4, la portion secondaire 322 est issue de même matière que la portion principale 321 de façon que la portion secondaire 322 s'étende perpendiculairement au plan de la portion principale 321.

Avantageusement, la portion secondaire 322 est pliée par rapport à la portion principale 321, ou directement moulée.

Alternativement, la portion secondaire 322 est fixée à la portion principale 321 ou encore soudée.

La portion secondaire 322 peut être pliée ou moulée différemment en fonction de si le support de fixation 30 est placé à droite ou à gauche de la face arrière 1-Ar.

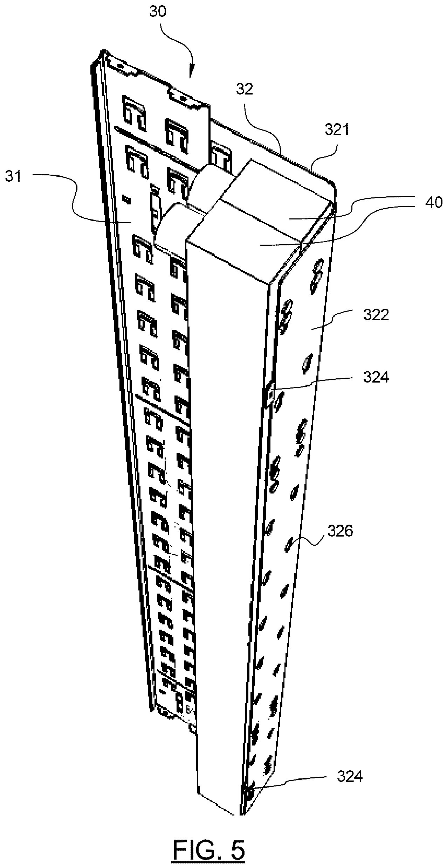

La portion secondaire 322 comprend des organes de fixation 324 permettant de monter l'unité d'alimentation électrique 40 de façon que l'ensemble de connecteurs fasse face à la face arrière 1-Ar, comme représenté sur la figure 5.

Dans les formes de réalisation représentées sur les figures 3 et 4, les organes de fixation 324 sont des orifices comprenant une partie large et une partie resserrée. L'unité d'alimentation électrique 40 comprend alors des crochets configurés pour être insérés dans la partie large de l'orifice et pour se verrouiller par gravité dans la partie resserrée afin d'assurer la fixation de l'unité d'alimentation électrique 40 lors de l'utilisation de l'armoire 1 comme représenté sur la figure 5.

Comme représenté sur les figures 3 et 4, les organes de fixations 324 sont répartis en une grille comprenant une pluralité de lignes et de colonnes. Chaque colonne permet de fixer une unité d'alimentation électrique 40.

Sur la forme de réalisation représentée sur la figure 3, la portion secondaire 322 comprend deux colonnes d'organes de fixations 324.

Sur la forme de réalisation représentée sur la figure 4, la portion secondaire 322 est plus large et comprend trois colonnes d'organes de fixations 324.

De préférence, la portion secondaire 322 comprend au moins une portion de fixation 326 à l'armature de support 20. Dans les formes de réalisation représentées sur les figures, ces portions de fixations 326 sont des portions métalliques pliées perpendiculairement au plan dans lequel s'étend la portion secondaire 322 et comprenant un orifice à travers lequel la portion secondaire 322 peut être vissée à l'armature de support 20.

L'armoire 1 comprend une unité d'alimentation électrique 40. L'unité d'alimentation électrique 40 est de forme parallélépipédique, de section réduite et de hauteur similaire à celle de l'armoire 1.

L'unité d'alimentation électrique 40 comprend une face de connexion et une face de fixation. La face de connexion comprend les connectiques destinées à être reliées électriquement aux lames de calcul 22 afin d'assurer leur alimentation électrique. La face de fixation est opposée à la face de connexion et comprend les organes de fixation complémentaires aux organes de fixation 324 de la partie secondaire 322 comme représenté sur la figure 5.

### Exemple de mise en oeuvre

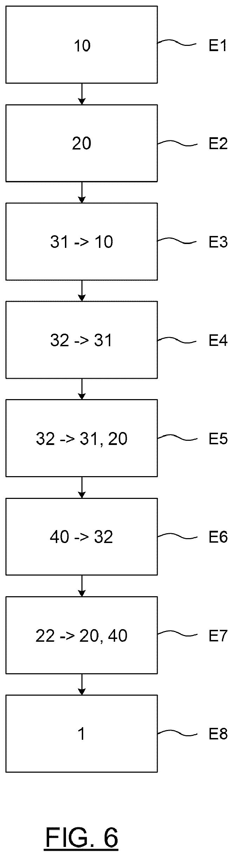

Le procédé de montage de l'armoire 1 comprenant au moins un support de fixation 30 est schématisé sur la figure 6.

Dans une étape E1, l'opérateur procède au montage de l'armature externe 10 de l'armoire 1 en fixant les montants, notamment les montants avant 11 et les montants arrière 12.

Ensuite, dans une étape E2, l'opérateur monte l'armature de support 20 de l'armoire 1 à l'intérieur de l'armature externe 10.

Dans une étape E3, la pièce fixe 31 du support de fixation 30 est fixée à l'armature extérieure 10. La pièce fixe 31 est vissée par les orifices des organes de fixation 311, et la pliure longitudinale 312 est insérée dans le rail d'un des montants arrière 12 de l'armature extérieure 10 comme représenté sur les figures.

Dans une étape E4, la pièce de déport 32 est positionnée par rapport à la pièce fixe 31 de façon à être adaptée aux caractéristiques souhaitées pour l'armoire 1, notamment sur le nombre d'unités d'alimentation électrique 40 et la taille des lames de calcul 22. Différentes formes de réalisation de la pièce de déport 32 peuvent être utilisées, comme représenté sur les figures 3 et 4.

Une fois que la pièce de déport 32 est positionnée, elle est fixée dans une étape E5 à la pièce fixe 31. Dans la forme de réalisation représentée sur les figures, des ensembles vis-écrous sont resserrés à travers les rainures de fixation 313 et des orifices de fixation 323. La pièce de déport 32 est également vissée par les orifices des organes de fixation 326 à l'armature de support 10.

Dans une étape E6, l'unité d'alimentation électrique 40 est montée sur la pièce de déport 32 ainsi fixée à l'armature externe 10 et l'armature de support 20. Dans la forme de réalisation représentée sur les figures, l'unité d'alimentation électrique 40 est positionnée de façon que sa face de fixation soit en vis-à-vis de la partie secondaire 322 de la pièce de déport 32, puis insérée dans les organes de fixation 324 de la partie secondaire 322.

Dans une étape E7, les lames de calculs 22 sont insérées de façon à être superposées verticalement dans l'armature de support 20.

Enfin, dans une étape E8, les lames de calcul 22 insérées sont raccordées électriquement à l'unité d'alimentation électrique 40 fixée au support de fixation 30 afin d'assurer leur alimentation et le fonctionnement de l'armoire 1.

L'armoire 1 de supercalculateur ainsi montée présente un espace interne optimisé du fait du support de fixation 30, qui permet de déporter les unités d'alimentation électrique 40 dans un espace entre l'armature externe 10 et l'armature de support 20 qui n'est pas utilisé. De plus, le montage de l'unité d'alimentation électrique 40 permet que la face de connexion soit en vis-à-vis de la face arrière de l'armoire 1, ce qui permet de d'insérer et de retirer les lames de calculs 22 sans risquer de provoquer des chocs avec les connecteurs de l'unité d'alimentation électrique 40. Enfin, le support de fixation 30 est simple à monter dans l'armoire 1 et ses différentes formes de réalisation permettent de prendre en compte les dimensions et les besoins spécifiques de chaque armoire 1.

## Revendications

1. Support de fixation (30) pour une armoire (1) de supercalculateur, ladite armoire (1) présentant une forme parallélépipédique comportant une face avant (1-Av), une face arrière (1-Ar), deux faces latérales (1-L), une armature extérieure (10), une armature de support (20) configurée pour recevoir une pluralité de lames de calcul (22) superposées verticalement et configurées pour être insérées et retirées de ladite armoire (1) par coulissement à travers la face arrière (1-Ar) de l'armoire (1), et au moins une unité d'alimentation électrique (40) configurée pour alimenter électriquement les composants des lames de calcul (22) et pour être fixée sur ledit support de fixation (30), ledit support de fixation (30) étant **caractérisé en ce qu'**il comporte une pièce fixe (31) et une pièce de déport (32), ladite pièce fixe (31) étant configurée pour être montée sur l'armature extérieure (10) de l'armoire (1) en s'étendant dans un plan parallèle au plan de la face latérale (1-L) et pour recevoir ladite pièce de déport (32), la pièce de déport (32) comprenant une portion principale (321) configurée pour être montée de manière réglable sur la pièce fixe (31) en s'étendant dans un plan parallèle au plan de ladite pièce fixe (31) et une portion secondaire (322) reliée à la portion principale (321) en s'étendant perpendiculairement au plan de ladite portion principale (321), ladite portion secondaire (322) étant configurée pour être fixée sur ladite armature de support (20) et pour recevoir l'au moins une unité d'alimentation électrique (40).

2. Support de fixation (30) selon la revendication 1, dans laquelle la portion secondaire (322) de la pièce de déport (32) est issue de même matière que la portion principale (321).

3. Support de fixation (30) selon l'une des revendications précédentes, dans lequel la portion principale (321) de la pièce de déport (32) est configurée pour être fixée à la pièce fixe (31) via un système vis-écrou.

4. Support de fixation (30) selon la revendication précédente, dans lequel la pièce fixe (31) comprend au moins une rainure de fixation (313) à travers laquelle l'ensemble vis-écrou est fixé.

5. Support de fixation (30) selon l'une quelconque des revendications précédentes, dans lequel la pièce fixe (31) et la portion principale (321) de la pièce de déport (32) comprennent un ensemble de perforations de fixation de câble (325).

6. Support de fixation (30) selon l'une quelconque des revendications précédentes, dans laquelle la pièce fixe (31) comprend une portion de renfort (312).

7. Support de fixation (30) selon l'une quelconque des revendications précédentes, dans laquelle la pièce de déport (32) comprend au moins une ouverture traversante (327).

8. Support de fixation (30) selon l'une quelconque des revendications précédentes, dans lequel la pièce fixe (31) et la pièce de déport (32) sont réalisées en un matériau métallique.

9. Armoire (1) de supercalculateur, ladite armoire (1) présentant une forme parallélépipédique comportant une face avant (1-Av), une face arrière (1-Ar), deux faces latérales (1-L), une armature extérieure (10) et une armature de support (20) configurée pour recevoir une pluralité de lames de calcul (22) superposées verticalement et configurées pour être insérées et retirées de ladite armoire (1) par coulissement à travers la face arrière (1-Ar) de l'armoire (1), au moins un support de fixation (30) selon l'une quelconque des revendications précédentes fixé à l'armature extérieure de l'armoire (1), et au moins une unité d'alimentation électrique (40) configurée pour alimenter électriquement les composants des lames de calcul (22) et fixée sur l'au moins un support de fixation (30).

10. Procédé de montage d'une armoire (1) de supercalculateur selon la revendication précédente, mis en oeuvre par un opérateur et comprenant les étapes de :
- montage (E1) de l'armature externe (10) de l'armoire (1),
- montage (E2) de l'armature de support (20), fixée à l'armature externe (10),
- fixation (E3) de la pièce fixe (31) du support de fixation (30) à l'armature externe (10),
- positionnement (E4) de la pièce de déport (32) du support de fixation (32) par rapport à la pièce fixe (31),
- fixation (E5) de la pièce de déport (32) à la pièce fixe (31) et à l'armature de support (20),
- fixation (E6) de l'unité d'alimentation électrique (40) sur la pièce de déport (32) ainsi fixée,
- insertion (E7) de la pluralité de lames de calcul (22) superposées verticalement dans l'armature de support (20),
- raccordement (E8) des lames de calcul (22) insérées à l'unité d'alimentation électrique (40) fixée afin d'alimenter électriquement les lames de calcul (22).
